# EUROPEAN PATENT APPLICATION

(11) **EP 4 709 066 A1**
(43) Date of publication of application: **11.03.2026**
(21) Application number: 24810217.0
(22) Date of filing: 09.05.2024
(51) Int. Cl.: H05K 5/02

(54) **ON-BOARD CHARGER HAVING COMPACT STRUCTURE**

(30) Priority: 19.05.2023 CN 202310570566
(71) Applicant: SHENZHEN VMAX NEW ENERGY (GROUP) CO., LTD, Shenzhen, Guangdong 518000 (CN)
(72) Inventor: FENG, Yingying, Shenzhen, Guangdong 518000 (CN); LUO, Yaowen, Shenzhen, Guangdong 518000 (CN)
(74) Representative: Santarelli
(86) International application number: PCT/CN2024/091998
(87) International publication number: WO 2024/239970

(57) **Abstract**

The present invention discloses a vehicle-mounted charger with a compact structure. The vehicle-mounted charger comprises a housing and a main circuit board arranged inside the housing. At least one auxiliary circuit board is arranged below the main circuit board, and an electric connection member is arranged between the main circuit board and the auxiliary circuit board; in a vertical direction, a second size component is arranged in a position at which the main circuit board is not overlapped with the auxiliary circuit board, a first size component is arranged in a position at which the main circuit board is overlapped with the auxiliary circuit board, and the first size component is arranged on the auxiliary circuit board; and a whole circuit board in the prior art is divided into a plurality of circuit boards.

## Description

### Technical Field

The present invention relates to the technical field of electric vehicle charging, in particular to a vehicle-mounted charger with a compact structure.

### Background of the Invention

At present, an electric vehicle is equipped with a vehicle-mounted charger, the vehicle-mounted charger serving as a key part for charging an electric vehicle battery in the electric vehicle can convert an alternating current of a charging point into a high-voltage direct current required by electric vehicle battery, thereby charging the electric vehicle battery.

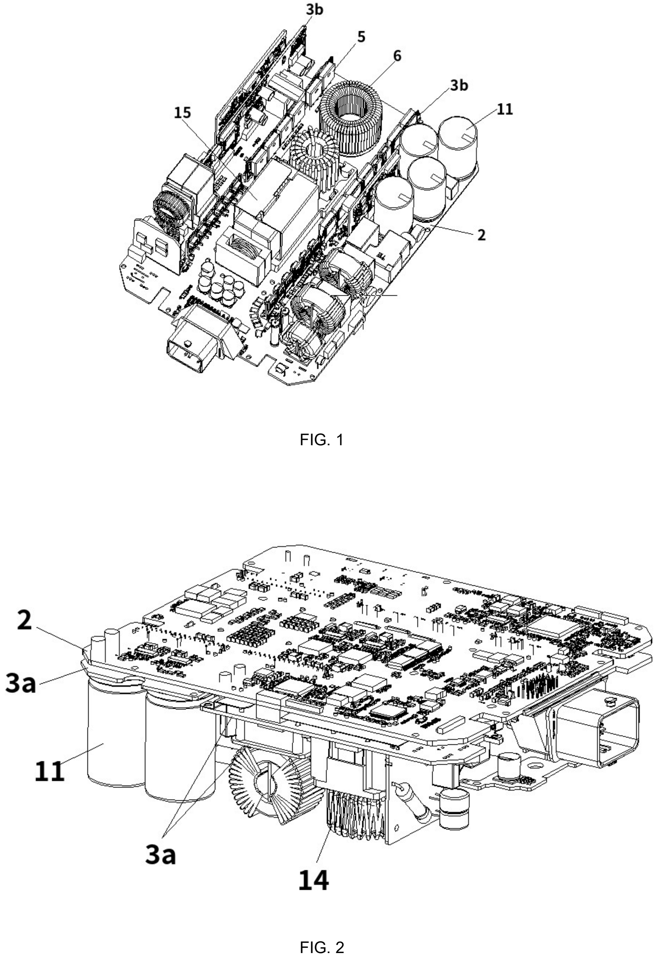

In the prior art, a schematic diagram of an internal structure of the vehicle-mounted charger is as shown in FIG. 1, and the vehicle-mounted charger is composed of a main board (circuit board) laid flat, in which several through-hole metal oxide semiconductor (MOS) switching transistors are used. In order to accelerate a charging speed of existing vehicle-mounted charger, it is necessary to increase power of the vehicle-mounted charger, and then it is necessary to arrange more devices on the main board to increase the power, so that a size of the main board needs to be increased, leading to a larger size of the existing charger. The through-hole MOS switching transistors can only be laid flat on the main board, which will occupy a projection area of the main board, so that the main board cannot accommodate more devices, and this problem can only be solved by increasing the size of the main board. Therefore, the vehicle-mounted charger is excessively large in size.

### Summary of the Invention

In order to solve the defects in the prior art, the present invention provides a vehicle-mounted charger with a compact structure.

The technical solutions used in the present invention are as follows.

The present invention provides a vehicle-mounted charger with a compact structure, wherein the vehicle-mounted charger comprises a housing and a main circuit board arranged inside the housing, wherein at least one auxiliary circuit board is arranged below the main circuit board, and an electric connection member is arranged between the main circuit board and the auxiliary circuit board; and a first size component is arranged in a position at which the main circuit board is overlapped with the auxiliary circuit board, and the first size component is arranged on the auxiliary circuit board.

Further, the auxiliary circuit board comprises a horizontal auxiliary board and/or a vertical auxiliary board, the horizontal auxiliary board and the main circuit board are horizontal to each other, and the vertical auxiliary board and the main circuit board are vertical to each other.

Preferably, the horizontal auxiliary boards are assembled together in a multi-layer overlapped structure.

Further, a cooling water passage is arranged in the housing, and the vertical auxiliary board is attached to a side wall of the cooling water passage.

Preferably, the vertical auxiliary board comprises an aluminum substrate, a surface-mount power switching transistor is arranged on the aluminum substrate, and a thermal grease or a thermal adhesive is coated between the aluminum substrate and the side wall of the cooling water passage.

Preferably, an end portion of the aluminum substrate is provided with a solder terminal, and the solder terminal is welded on the main circuit board.

Further, the cooling water passage is in a U-shaped layout in a top-view projection, a cooling cavity is surrounded by the cooling water passage, a magnetic element is arranged in the cooling cavity, and the magnetic element is welded on the main circuit board.

Preferably, a thermal adhesive or a thermal grease is encapsulated between the magnetic element and the cooling water passage.

Further, a shielding cover is arranged between the main circuit board and the auxiliary circuit board, and a shielding cover is arranged between two adjacent auxiliary circuit boards; and insulating sheets are arranged between the shielding cover and the main circuit board and between the shielding cover and the auxiliary circuit board.

Preferably, a structural fixing member is arranged between the main circuit board and the auxiliary circuit board, and the structural fixing member adopts one or more of a copper column, a steel column, an aluminum column and an iron column.

Compared with the prior art: according to the present invention, a whole circuit board in the prior art is divided into a plurality of circuit boards, and the plurality of circuit boards are reasonably arranged inside the housing according to a height of the housing and a shape and a position of a cooling water passage inside the housing to enrich a space in the housing, so that a power density of the housing is greatly improved, and in the case of the same power, the vehicle-mounted charger has a smaller size compared with existing similar vehicle-mounted chargers; and meanwhile, the vehicle-mounted charger has the advantages of reasonable layout, compact structure and small electromagnetic interference.

### Brief Description of the Drawings

The present invention is described in detail hereinafter with reference to the embodiments and the drawings, wherein:
FIG. 1 is a schematic diagram of a circuit board in the prior art;
FIG. 2 is a schematic diagram of a main circuit board and a plurality of auxiliary circuit boards which are overlapped together from a left view in one optional embodiment of the present invention;
FIG. 3 is a schematic diagram of the main circuit board and the plurality of auxiliary circuit boards which are overlapped together from the left view in one optional embodiment of the present invention;
FIG. 4 is a schematic diagram of the main circuit board and the plurality of auxiliary circuit boards which are overlapped together from a right view in one optional embodiment of the present invention;
FIG. 5 is a schematic diagram of two auxiliary circuit boards overlapped together in one optional embodiment of the present invention;
FIG. 6 is a stereoscopic diagram of an aluminum substrate in one optional embodiment of the present invention;
FIG. 7 is a schematic diagram of connection between the aluminum substrate and the main circuit board in one optional embodiment of the present invention;
FIG. 8 is a schematic diagram of the aluminum substrate attached to a side wall of a cooling water passage in one optional embodiment of the present invention;
FIG. 9 is a schematic diagram of the aluminum substrate pressed on the side wall of the cooling water passage by a clamping strip in one optional embodiment of the present invention; and
FIG. 10 is a sectional view of one optional embodiment of the present invention.

Description of reference numerals: 1 - housing; 2 - main circuit board; 3a - horizontal auxiliary board; 3b - vertical auxiliary board; 4 - cooling water passage; 5 - power switching transistor; 6 - magnetic element; 7 - structural fixing member; 8 - shielding cover; 9 - insulating sheet; 10 - solder terminal; 11 - electrolytic capacitor; 12 - inlet and outlet; 13 - side wall; 14 - inductor; 15 - transformer; and 16 - clamping strip.

### Detailed Description of Embodiments

To make the objectives, the technical solutions and the advantages of the present invention clearer, the present invention is further described in detail hereinafter with reference to the drawings and the embodiments. It should be understood that the specific embodiments described herein are only used for explaining the present invention and are not intended to limit the present invention.

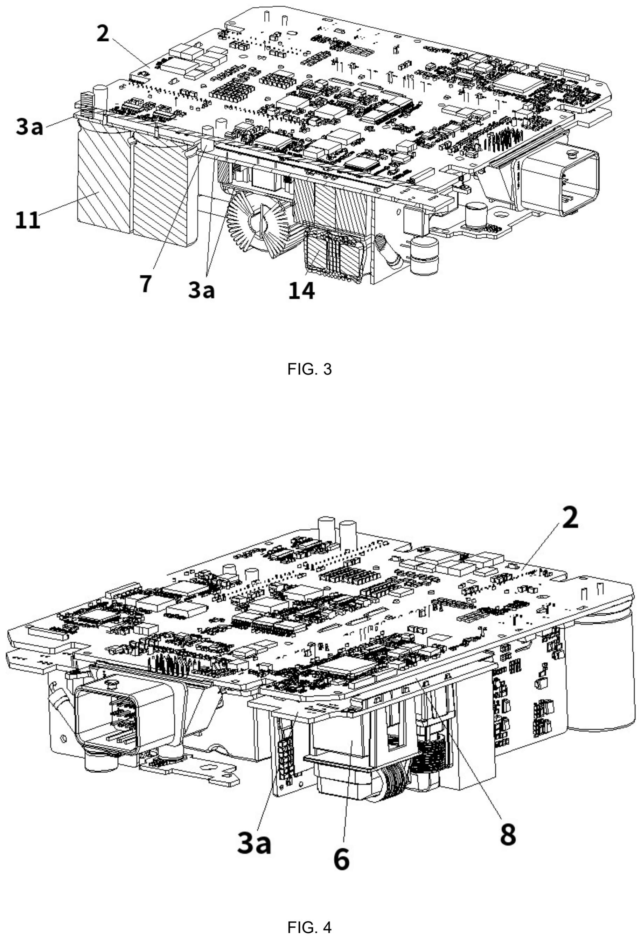

The present invention provides a vehicle-mounted charger with a compact structure. With reference to FIG. 2 which shows a schematic diagram of a main circuit board and a plurality of auxiliary circuit boards which are overlapped together from a left view in one optional embodiment of the present invention, the vehicle-mounted charger comprises a housing 1 and a main circuit board 2 arranged inside the housing 1, wherein at least one auxiliary circuit board is arranged below the main circuit board 2, and an electric connection member is arranged between the main circuit board 2 and the auxiliary circuit board. Further, with reference to FIG. 3 which shows a schematic diagram of the main circuit board and the plurality of auxiliary circuit boards which are overlapped together from the left view in one optional embodiment of the present invention, in a vertical direction, a second size component (an electrolytic capacitor referred by reference numeral 11) is arranged in a position at which the main circuit board 2 is not overlapped with the auxiliary circuit board, a first size component (an inductor 14, a capacitor and other surface-mount devices) is arranged in a position at which the main circuit board 2 is overlapped with the auxiliary circuit board, and the first size component is arranged on the auxiliary circuit board. The electric connection member may be, but is not limited to: a solder terminal, a flexible flat cable connector, a press-fit connector, and the like.

It should be pointed out that, according to the present invention, the second size component is a high-size component with a length greater than a second preset value, wherein the second preset value is 45.5 mm; and the first size component is a low-size component with a length not greater than a first preset value, wherein the first preset value is 45.5 mm. The orientation term "below" is used in the present invention to indicate a positional relationship between components, and is not used to limit the structure and essence of the present invention.

According to the present invention, a whole circuit board in the prior art is divided into a plurality of circuit boards, a height of the housing is fully utilized, the plurality of circuit boards are reasonably arranged inside the housing, and there is no large vacant area inside the housing used, so that a power density of the housing is greatly improved. Compared with existing similar vehicle-mounted charger, the vehicle-mounted charger has a smaller volume under the same power.

According to the present invention, the auxiliary circuit board comprises, but is not limited to, a horizontal auxiliary board 3a and/or a vertical auxiliary board 3b. With reference to FIG. 4 which shows a schematic diagram of the main circuit board and the plurality of auxiliary circuit boards which are overlapped together from a right view in one optional embodiment of the present invention, the horizontal auxiliary board 3a and the main circuit board 2 are horizontal to each other, and the vertical auxiliary board 3b and the main circuit board 2 are vertical to each other.

In the optional embodiment, some of the horizontal auxiliary boards 3a adopt a surface-mount technology, and an overall height (circuit boards plus surface-mount elements) of the horizontal auxiliary boards 3a is not high, so that multiple layers of the horizontal auxiliary boards 3a may be overlapped and assembled together.

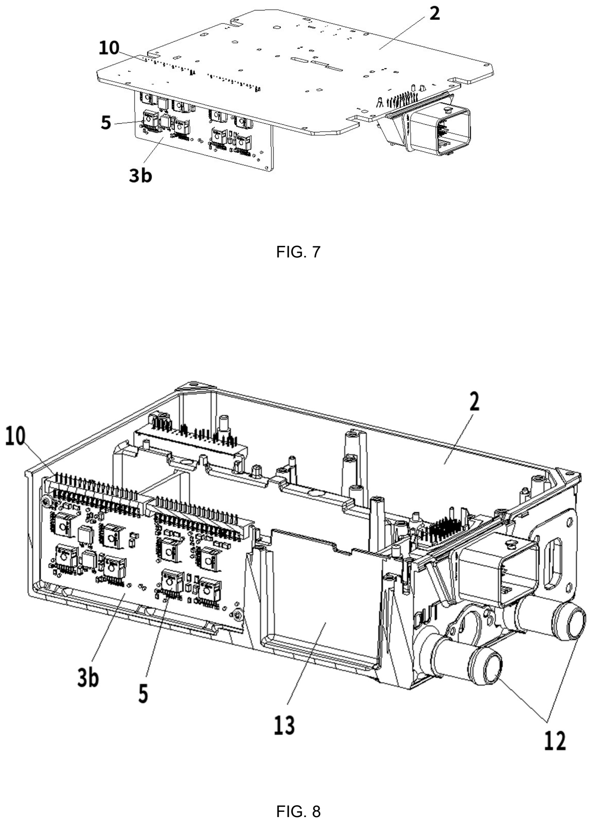

In the optional embodiment, a cooling water passage 4 is arranged in the housing 1, and the vertical auxiliary board 3b is attached to a side wall of the cooling water passage 4. With reference to the embodiment as shown in FIG. 8, FIG. 9 and FIG. 10, the reference numeral 12 refers to an inlet and an outlet of the cooling water passage 4, and the reference numeral 13 refers to a side wall of the cooling water passage 4. When the vehicle-mounted charger works, a cooling liquid will circulate in the cooling water passage 4, and the cooling liquid takes away heat generated by the vehicle-mounted charger, so as to improve the safety and stability of the vehicle-mounted charger.

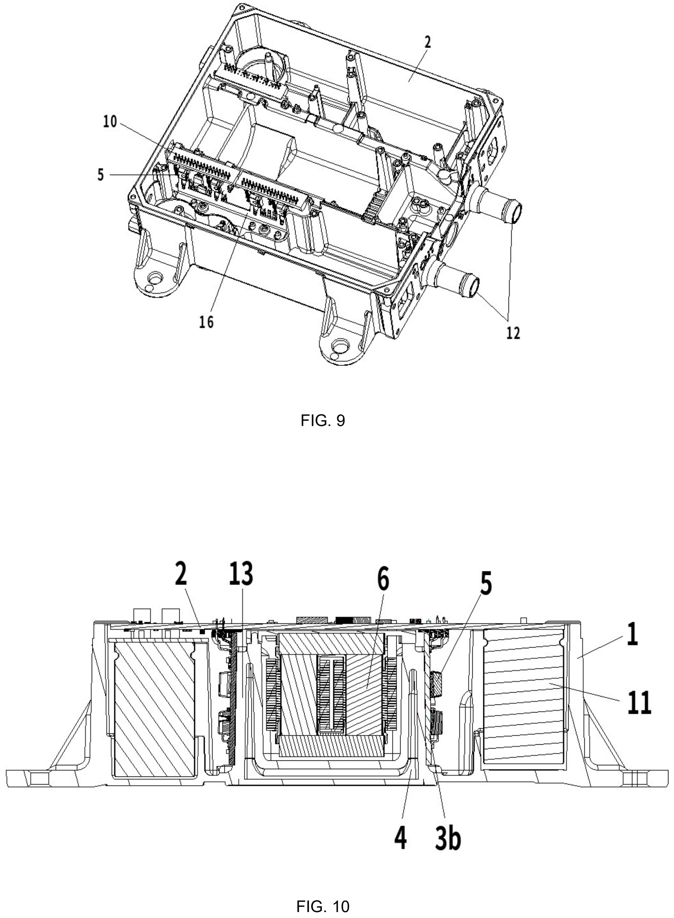

In the optional embodiment, the vertical auxiliary board 3b comprises an aluminum substrate, and a surface-mount power switching transistor 5 is arranged on the aluminum substrate. On one hand, a plurality of surface-mount power switching transistors 5 may be arranged on the aluminum substrate, and more elements may be arranged than existing technology adopting a through-hole switch, thereby reducing a volume of the vehicle-mounted charger; and meanwhile, the aluminum substrate is vertically arranged, which may make full use of the height of the vehicle-mounted charger, thereby reducing the volume of the vehicle-mounted charger. On the other hand, the vertical auxiliary board 3b comprises the aluminum substrate, and the aluminum substrate has good thermal conductivity, so that heat generated by the power switching transistor 5 may be taken away as soon as possible, thereby reducing a temperature of the power switching transistor 5. FIG. 8 is a schematic diagram of the aluminum substrate attached to the side wall of the cooling water passage in one optional embodiment of the present invention, FIG. 9 is a schematic diagram of the aluminum substrate pressed on the side wall of the cooling water passage by a clamping strip in one optional embodiment of the present invention (the reference numeral 16 refers to the clamping strip, wherein one end of the clamping strip is fixed on the housing 1, and the other end of the clamping strip is pressed on the aluminum substrate or the power switching transistor 5), and FIG. 10 is a sectional view of one optional embodiment of the present invention. A positional relationship among the housing 1, the cooling water passage 4 and the aluminum substrate can be clearly seen from the figures. There are various connection modes between the aluminum substrate and the side wall 13, comprising, but being not limited to: fixing the aluminum substrate on the side wall 13 by adhesive bonding; fixing the aluminum substrate on the side wall 13 by screw fixation; and fixing the aluminum substrate on the side wall 13 by pressing via the clamping strip 13.

In order to improve heat conduction efficiency of the aluminum substrate, in a preferred embodiment, a thermal grease or a thermal adhesive is coated between the aluminum substrate and the side wall of the cooling water passage 4 to reduce thermal resistance between the aluminum substrate and the cooling water passage 4, so that heat on the aluminum substrate is efficiently transferred to the cooling water passage 4.

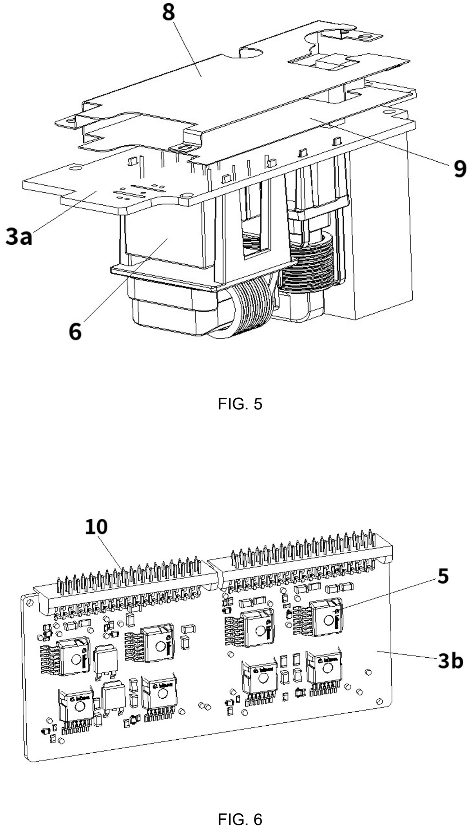

The aluminum substrate and the main circuit board 2 are vertical to each other. In order to facilitate connecting the aluminum substrate and the main circuit board, in the optional embodiment, an end portion of the aluminum substrate is provided with a solder terminal 10 (with reference to FIG. 6 which shows a stereoscopic diagram of the aluminum substrate in one optional embodiment of the present invention;), and the solder terminal 10 is welded on the main circuit board 2 (with reference to FIG. 7 which shows a schematic diagram of connection between the aluminum substrate and the main circuit board in one optional embodiment of the present invention).

In a preferred embodiment, the cooling water passage 4 is in a U-shaped layout in a top-view projection, a cooling cavity is surrounded by the cooling water passage 4, and with reference to FIG. 10 which shows a sectional view of one optional embodiment of the present invention, a magnetic element 6 is arranged in the cooling cavity, and the magnetic element 6 is welded on the main circuit board 2. **In** a preferred embodiment, the magnetic element 6 comprises, but is not limited to, a transformer 15 and an inductor. Characteristics of the transformer and the inductor in the vehicle-mounted charger are: a large size and large heat generated during working. Therefore, it is necessary to give priority to solving the heat dissipation problem.

In order to improve heat conduction efficiency of the magnetic element 6, in a preferred embodiment, a thermal adhesive or a thermal grease is encapsulated between the magnetic element 6 and the cooling water passage 4.

In order to reduce an electromagnetic interference between circuit boards, a shielding cover 8 is arranged between the main circuit board 2 and the auxiliary circuit board, and a shielding cover 8 is arranged between two adjacent auxiliary circuit boards. With reference to FIG. 5 which shows a schematic diagram of two auxiliary circuit boards overlapped together in one optional embodiment of the present invention, insulating sheets 9 are arranged between the shielding cover 8 and the main circuit board 2 and between the shielding cover 8 and the auxiliary circuit board, so as to ensure an insulation performance between adjacent circuit boards.

Optionally, a structural fixing member 7 is arranged between the main circuit board 2 and the auxiliary circuit board, and the structural fixing member 7 adopts one or more of a copper column, a steel column, an aluminum column and an iron column. The structural fixing member 7 may be connected with the main circuit board 2 and the auxiliary circuit board by welding or screwing.

The above embodiments are only for illustration, and are not for limitation. Any equivalent modification or change made without departing from the spirit and scope of the present application should be included in the scope of the claims of the present application.

## Claims

1. A vehicle-mounted charger with a compact structure, comprising a housing (1) and a main circuit board (2) arranged inside the housing (1), wherein at least one auxiliary circuit board is arranged below the main circuit board (2), and an electric connection member is arranged between the main circuit board (2) and the auxiliary circuit board; and a first size component is arranged in a position at which the main circuit board (2) is overlapped with the auxiliary circuit board, and the first size component is arranged on the auxiliary circuit board.

2. The vehicle-mounted charger with the compact structure according to claim 1, wherein the auxiliary circuit board comprises a horizontal auxiliary board (3a) and/or a vertical auxiliary board (3b), the horizontal auxiliary board (3a) and the main circuit board (2) are horizontal to each other, and the vertical auxiliary board (3b) and the main circuit board (2) are vertical to each other.

3. The vehicle-mounted charger with the compact structure according to claim 2, wherein the horizontal auxiliary boards (3a) are assembled together in a multi-layer overlapped structure.

4. The vehicle-mounted charger with the compact structure according to claim 2, wherein a cooling water passage (4) is arranged in the housing (1), and the vertical auxiliary board (3b) is attached to a side wall of the cooling water passage (4).

5. The vehicle-mounted charger with the compact structure according to claim 4, wherein the vertical auxiliary board (3b) comprises an aluminum substrate, a surface-mount power switching transistor (5) is arranged on the aluminum substrate, and a thermal grease or a thermal adhesive is coated between the aluminum substrate and the side wall of the cooling water passage (4).

6. The vehicle-mounted charger with the compact structure according to claim 5, wherein an end portion of the aluminum substrate is provided with a solder terminal (10), and the solder terminal (10) is welded on the main circuit board (2).

7. The vehicle-mounted charger with the compact structure according to claim 4, wherein the cooling water passage (4) is in a U-shaped layout in a top-view projection, a cooling cavity is surrounded by the cooling water passage (4), a magnetic element (6) is arranged in the cooling cavity, and the magnetic element (6) is welded on the main circuit board (2).

8. The vehicle-mounted charger with the compact structure according to claim 7, wherein a thermal adhesive or a thermal grease is encapsulated between the magnetic element (6) and the cooling water passage (4).

9. The vehicle-mounted charger with the compact structure according to claim 1, wherein a shielding cover (8) is arranged between the main circuit board (2) and the auxiliary circuit board, and a shielding cover (8) is arranged between two adjacent auxiliary circuit boards; and insulating sheets (9) are arranged between the shielding cover (8) and the main circuit board (2) and between the shielding cover (8) and the auxiliary circuit board.

10. The vehicle-mounted charger with the compact structure according to claim 1, wherein a structural fixing member (7) is arranged between the main circuit board (2) and the auxiliary circuit board, and the structural fixing member (7) adopts one or more of a copper column, a steel column, an aluminum column and an iron column.
